# EUROPEAN PATENT SPECIFICATION

(11) **EP 3 913 805 B1**
(45) Date of publication and mention of the grant of the patent: **01.10.2025**
(21) Application number: 19910433.2
(22) Date of filing: 12.11.2019
(51) Int. Cl.: H03K 17/51, H01H 71/00

(54) **FULL-BRIDGE MODULE, HYBRID DIRECT CURRENT CIRCUIT BREAKER OF FULL-BRIDGE MODULE, AND APPLICATION METHOD**
VOLLBRÜCKENMODUL, HYBRIDER GLEICHSTROMLEISTUNGSSCHALTER EINES VOLLBRÜCKENMODULS UND ANWENDUNGSVERFAHREN
MODULE À PONT COMPLET, DISJONCTEUR À COURANT CONTINU HYBRIDE DE MODULE À PONT COMPLET, ET PROCÉDÉ D'APPLICATION

(30) Priority: 14.01.2019 CN 201910030591
(43) Date of publication of application: 24.11.2021
(73) Proprietor: Global Energy Interconnection Research Institute Co., Ltd, Beijing 102211 (CN); State Grid Corporation of China, Beijing 100031 (CN)
(72) Inventor: GAO, Chong, Beijing 102211 (CN); ZHOU, Wandi, Beijing 102211 (CN); WEI, Xiaoguang, Beijing 102211 (CN); WANG, Huafeng, Beijing 102211 (CN); ZHANG, Sheng, Beijing 102211 (CN); LI, Pengzhi, Beijing 102211 (CN)
(74) Representative: Cabinet Beaumont
(86) International application number: PCT/CN2019/117572
(87) International publication number: WO 2020/147400

(56) References cited:
- CN-A- 105 896 492
- CN-A- 105 896 492
- CN-A- 106 971 883
- CN-A- 107 482 576
- CN-A- 107 748 324
- CN-A- 109 981 092
- CN-B- 106 229 952
- CN-B- 107 749 616
- CN-U- 205 693 347
- CN-U- 205 693 347
- US-A1- 2016 105 018

## Description

### TECHNICAL FIELD

The present disclosure belongs to the technical field of power electronics, for example, relates to a full-bridge module, a hybrid direct current circuit breaker based on a full-bridge module, and an application method of a hybrid direct current circuit breaker.

### BACKGROUND

A high-voltage direct current circuit breaker has become one of the key equipment to ensure stable, safe and reliable operation of a system with the application of a multiterminal voltage source converter based high-voltage direct current transmission (VSC-HVDC) and direct current power grid technology. The direct current circuit breaker technology combines a mechanical switch and a fully-controlled power electronic switch, so that the direct current circuit breaker technology has both the low loss characteristic of the mechanical switch and the fast breaking characteristic of the power electronic switch. Thus, the direct current circuit breaker technology is one of the most effective technical ways to apply direct current breaking in a high-voltage transmission system. When applied to a multiterminal VSC-HVDC and direct current power grid with high-capacity overhead lines, the high-voltage direct current circuit breaker should not only have the characteristics of high speed and low loss, but also have strong current breaking and high working reliability.

In the related art, a full-bridge-based hybrid direct current circuit breaker has the ability to cut off a fault current of 25 kA in 3 ms and has good technical performance, laying a solid foundation for engineering application. However, in the topology structure of the full-bridge-based hybrid direct current circuit breaker, each device needs to be connected in parallel with resistance-capacitance and damping circuits, which requires a large number of capacitors, thus increasing the overall volume of the circuit breaker and not conducive to a compact design. A full-bridge sub-module has also been disclosed in the related art, and requires a large number of insulated gate bipolar transistor (IGBT) devices, thus increasing the cost and the overall volume of the circuit breaker. Due to the existence of a large number of IGBTs, and each IGBT is driven separately, the required driving power is large and the secondary wiring is complicated. Meanwhile, the reliability of driving control will be reduced and the performance of the circuit breaker will be affected.

CN107749616B discloses a loss-reducing capacitive DC circuit breaker and a DC fault handling strategy thereof. The loss-reducing capacitive DC circuit breaker includes a normal flow branch, a cut-off branch, a reactor, and a disconnecting switch. The normal flow branch is composed of an ultra-fast mechanical switch and a load transfer switch connected in series. The cut-off branch is composed of a main circuit breaker. The load transfer switch is composed of a plurality of sub modules, The main circuit breaker can be composed of a plurality of enhanced half-bridge sub-modules in series-parallel connection.

CN106971883A relates to a direct current circuit breaker, the direct current circuit breaker including a first mechanical switch (K1), a first capacitor (C1), a second capacitor (C2), a third capacitor (C3), a first fully controlled switching device (S1), a second fully controlled switching device (S2), a third fully controlled switching device (S3), a fourth fully controlled switching device (S4), a fifth fully controlled switching device (S5), a sixth fully controlled switching device (S 6), a seventh fully controlled switching device (S7), an eighth fully controlled switching device (S8), a first half controlled switching device (T1), a second half controlled switching device (T2), and a first arrester (Z1). By adjusting the conduction break of the fully controlled switching device and the semi-controlled switching device, the fault current of the DC power network can be quickly broken.

### SUMMARY

To solve the problem existing in the related art, the present disclosure provides a full-bridge module, a hybrid direct current circuit breaker based on a full-bridge module, and an application method of a hybrid direct current circuit breaker.

The invention is set out in the appended set of claims.

### BRIEF DESCRIPTION OF DRAWINGS

FIG. 1 A is a schematic diagram showing a full-bridge module in which anodes of diodes in a lower leg are connected together according to an embodiment of the present disclosure;
FIG. 1B is a schematic diagram showing a full-bridge module in which cathodes of diodes in a lower leg are connected together according to an embodiment of the present disclosure;
FIG. 2A is a schematic diagram showing a full-bridge module whose power electronic unit is formed by a single fully-controlled power electronic device according to an embodiment of the present disclosure;
FIG. 2B is a schematic diagram showing a full-bridge module whose power electronic unit is formed by fully-controlled power electronic devices connected in parallel according to an embodiment of the present disclosure;
FIG. 2C is a schematic diagram showing a full-bridge module whose power electronic unit is formed by fully-controlled power electronic devices connected in series according to an embodiment of the present disclosure;
FIG. 2D is a schematic diagram showing a full-bridge module whose power electronic unit is formed by fully-controlled power electronic devices first connected in parallel and then connected in series according to an embodiment of the present disclosure;
FIG. 2E is a schematic diagram showing a full-bridge module whose power electronic unit is formed by fully-controlled power electronic devices first connected in series and then connected in parallel according to an embodiment of the present disclosure;
FIG. 3A is a schematic diagram of a path in which a current flows from left to right when a full-bridge module is turned on according to an embodiment of the present disclosure;
FIG. 3B is a schematic diagram showing a path in which a current flows from right to left when a full-bridge module is turned on according to an embodiment of the present disclosure;
FIG. 4A is a schematic diagram showing a path in which a current flows from left to right when a full-bridge module is turned off according to an embodiment of the present disclosure;
FIG. 4B is a schematic diagram showing a path in which a current flows from right to left when a full-bridge module is turned off according to an embodiment of the present disclosure;
FIG. 5 is a schematic diagram of a topology structure of a hybrid direct current circuit breaker according to an embodiment of the present disclosure;
FIG. 6A is a schematic diagram in which power electronic switches are first connected in series and then connected in parallel in a primary path branch of a hybrid direct current circuit breaker according to an embodiment of the present disclosure;
FIG. 6B is a schematic diagram in which power electronic switches are first connected in parallel and then connected in series in a primary path branch of a hybrid direct current circuit breaker according to an embodiment of the present disclosure; and
FIG. 7 is a schematic diagram of a topology structure of a hybrid direct current circuit breaker using a full-bridge module according to an embodiment of the present disclosure.

### DETAILED DESCRIPTION

To understand the present disclosure, the content of the present disclosure is described with reference to drawings and examples of the description.

Since a relatively large number of damping components and high-potential control units are adopted in the hybrid direct current circuit breaker, the hybrid direct current circuit breaker has the characteristics of complex structure design and complex control electrical wiring. Therefore, a full-bridge module and an application method thereof in a hybrid direct current circuit breaker are provided, which simplifies the topology structure of a cascade full-bridge direct current circuit breaker, reduces the number of high-potential control units, electrical wiring and power requirements, and conducive to a reduction of the overall volume of the circuit breaker and the improvement of working reliability.

### Example one

A full-bridge module is provided in an example and includes two power electronic units, two diodes, a resistor and a capacitor.

The two power electronic units are connected in reverse series to form an upper leg.

The two diodes are connected in series to form a lower leg, and anodes or cathodes of the two diodes are connected together.

The resistor and the capacitor are connected in parallel and then connected between the upper leg and the lower leg.

The power electronic unit includes one or more sub-modules, each of the one or more sub-modules is formed by a fully-controlled power electronic device in inverse-parallel connection with one diode and the diode, and a direction of a diode of each power electronic unit is opposite to a direction of one diode of the lower leg corresponding to the each power electronic unit.

In a case of a plurality of sub-modules, the plurality of sub-modules are connected in a manner including: in series, in parallel, first in series and then in parallel, and first in parallel and then in series.

The fully-controlled power electronic device includes: an IGBT, an integrated gate commutated thyristors (IGCT), an injection enhanced gate transistor (IEGT), or a gate turn-off thyristor (GTO). A hybrid direct current circuit breaker based on a full-bridge module is provided in an embodiment of the present disclosure and includes a primary path branch, a transfer branch and an energy absorption branch, where the primary path branch, the transfer branch and the energy absorption branch are connected in parallel.

The primary path branch includes a plurality of full-bridge modules of any one of the preceding embodiments.

The transfer branch includes a plurality of fully-controlled power electronic devices or a plurality of units including a fully-controlled power electronic device.

The primary path branch further includes a switch connected in series to the plurality of full-bridge modules.

The energy absorption branch includes a varistor.

The plurality of full-bridge modules in the primary path branch are connected first in parallel and then in series or connected first in series and then in parallel.

The plurality of fully-controlled power electronic devices or the plurality of units including the fully-controlled power electronic device in the transfer branch are connected in series.

An application method of a hybrid direct current circuit breaker is further provided in the present disclosure and includes steps described below.

In condition that a system in which the hybrid direct current circuit breaker is located operates normally, a switch of the primary path branch of the hybrid direct current circuit breaker is closed and a full-bridge module of the primary path branch is kept at a trigger state.

In condition that the system in which the hybrid direct current circuit breaker is located fails, the full-bridge module of the primary path branch is turned off, a fully-controlled power electronic device of a transfer branch is kept at a trigger state, and after a fault current is transferred to the transfer branch, the switch of the primary path branch is opened.

After the fault current is transferred to the energy absorption branch of the hybrid direct current circuit breaker, the hybrid direct current circuit breaker clears the fault current.

In an embodiment, the step in which in condition that a system in which the hybrid direct current circuit breaker is located operates normally, a switch of the primary path branch of the hybrid direct current circuit breaker is closed and a full-bridge module of the primary path branch is kept at a trigger state includes a step described below.

The current passes from an input end through a diode in inverse-parallel connection with a fully-controlled power electronic device in one power electronic unit of the upper leg of the full-bridge module, and then passes through a fully-controlled power electronic device in the other power electronic unit of the upper leg to flow out of the full-bridge module.

In an embodiment, the step in which in condition that the system in which the hybrid direct current circuit breaker is located fails, the full-bridge module of the primary path branch is turned off, a fully-controlled power electronic device of a transfer branch is kept at a trigger state, and after a fault current is transferred to the transfer branch, the switch of the primary path branch is opened includes steps described below.

Based on a received breaking command, the fully-controlled power electronic device of the full-bridge module of the primary path branch is turned off, and a capacitor of the full-bridge module of the primary path branch is charged through the fault current.

In condition that a voltage across two ends of the hybrid direct current circuit breaker reaches a turn-on voltage of the transfer branch, the fault current is transferred to the transfer branch.

After the fault current transfer is completed, the switch of the primary path branch is opened.
1. The full-bridge module provided in the present disclosure includes two power electronic units, two diodes, a resistor and a capacitor. The two power electronic units are connected in reverse series to form an upper leg. The two diodes are connected in series to form a lower leg, and anodes or cathodes of the two diodes are connected together. The resistor and the capacitor are connected in parallel and then connected between the upper leg and the lower leg. Thus, common damping of devices connected in reverse series is achieved, the number of passive elements is reduced, and the topology design is simplified, conducive to a reduction of the volume and cost of equipment.
2. The full-bridge module, the hybrid direct current circuit breaker based on a full-bridge module, and an application method are provided in the present disclosure, achieving the potential unification of fully-controlled power electronic devices, conducive to a reduction of the number of high-potential control units, simplifying the control electrical wiring, and conducive to the improvement of the overall reliability of equipment.
3. The full-bridge module, the hybrid direct current circuit breaker based on a full-bridge module, and an application method are provided in the present disclosure, achieving the compact press-fitting structure design of fully-controlled power electronic devices of the hybrid direct current circuit breaker, easy to reduce stray parameters and to achieve overvoltage suppression, and improving the overall application reliability and economy.

### Example two

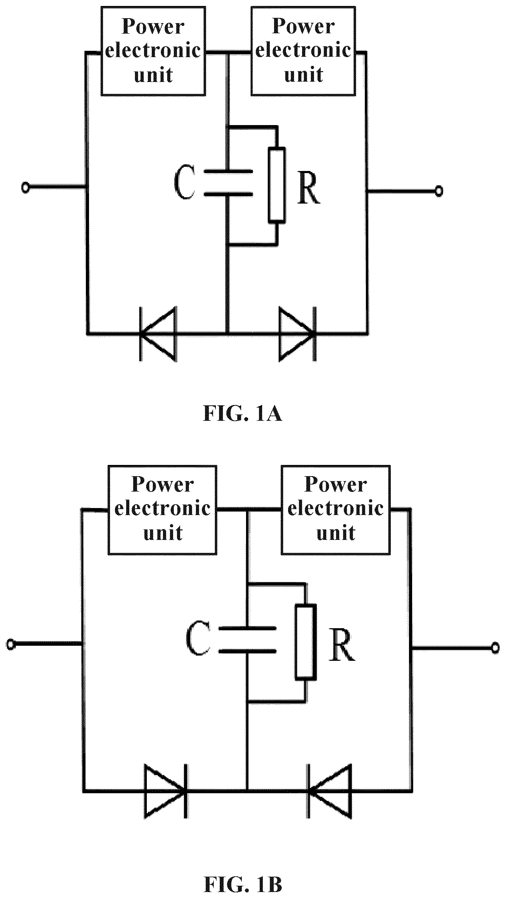

In an example, a full-bridge module includes power electronic units, diodes, a resistor and a capacitor. A full-bridge structure is formed by two power electronic units and two diodes. The capacitor and a resistor R are connected in parallel and then connected between the upper leg and the lower leg of the full-bridge module. As shown in FIG. 1, the full-bridge module has two basic structures. The two diodes may be connected to each other with a common anode, as shown in FIG. 1 A, and the two diodes may be connected to each other with a common cathode, as shown in FIG. 1 B. The module as drawn in figure 1B is an embodiment of the invention.

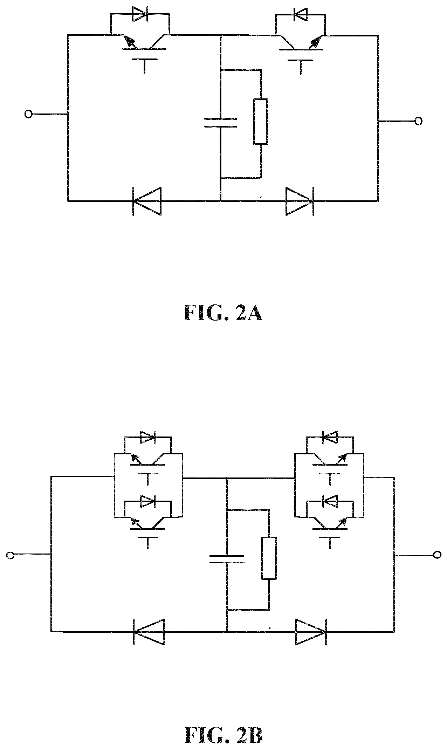

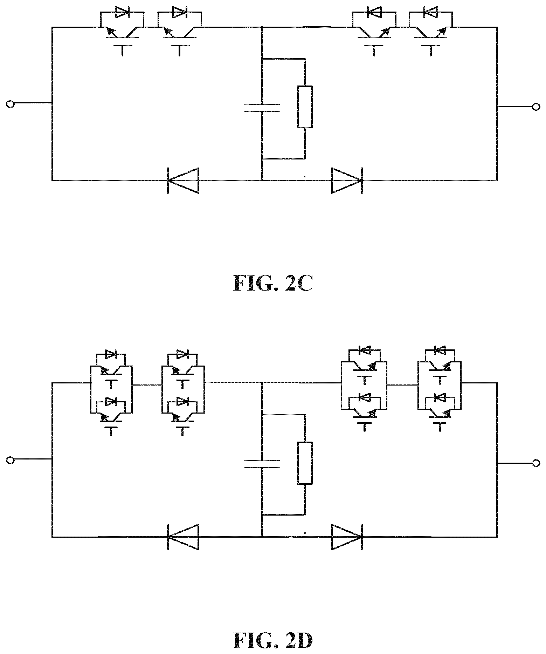

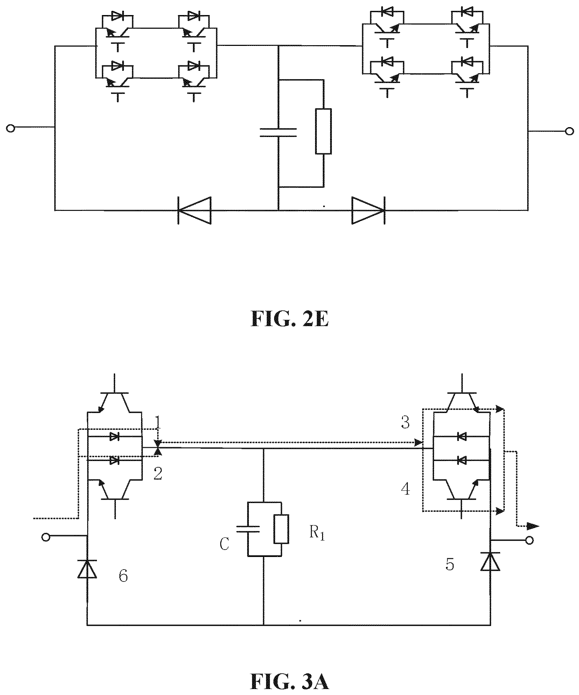

The power electronic unit in the full-bridge module also has two implementation forms: the power electronic unit may be formed by a single fully-controlled power electronic device, or may be formed by fully-controlled power electronic devices connected in series, in parallel or a combination thereof. The fully-controlled power electronic device may be an IGBT, an IGCT, an IEGT, a GTO or another power electronic device. Embodiments are as shown in FIG. 2 A, FIG. 2 B, FIG. 2C, FIG. 2D and FIG. 2E.

In an embodiment, the full-bridge module operates as described below.

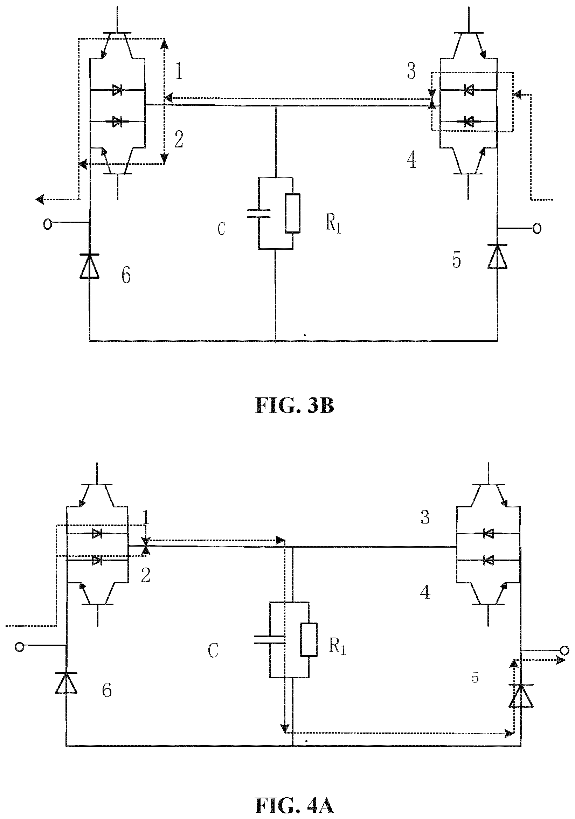

When the full-bridge module is turned on, if a current flows from left to right, the current flows through the diodes connected anti-parallel to IGBT1 and to IGBT2 respectively and flows through IGBT3 and IGBT4, as shown in FIG. 3A; and if a current flows from right to left, the current flows through the diodes connected anti-parallel to IGBT3 and IGBT4 respectively and flows through IGBT1 and IGBT2, as shown in FIG. 3B.

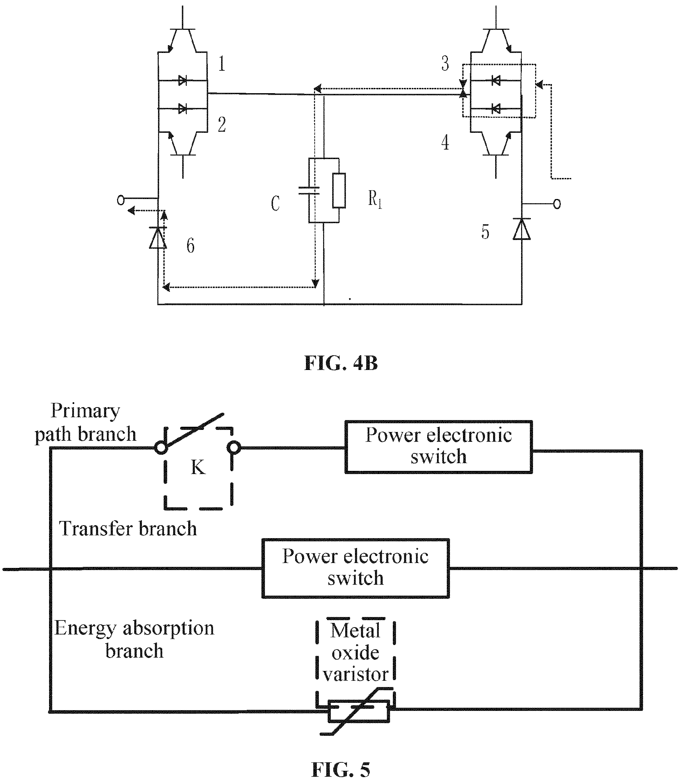

When the full-bridge module is turned off, if a current flows from left to right, the current flows through the diodes connected anti-parallel to IGBT1 and to IGBT2 respectively and flows through the capacitor of the module and a diode 5, as shown in FIG. 4A; and if a current flows from right to left, the current flows through the diodes connected anti-parallel to IGBT3 and IGBT4 respectively and flows through the capacitor of the module and a diode 6, as shown in FIG. 4B.

As shown in FIG. 5, a hybrid direct current circuit breaker includes three branches connected in parallel with each other: a primary path branch, a transfer branch and an energy absorption branch. The primary path branch includes a fast mechanical switch K and a small number of power electronic switches and is configured to carry the rated current of a system when the system normally operates. The transfer branch includes fully-controlled power electronic devices connected in series or units formed by fully-controlled power electronic devices and connected in series, and is configured to break the short-circuit current of the system. The energy absorption branch includes multiple groups of lightning arrester units and is configured to absorb the inductive energy of the system and remove a fault current.

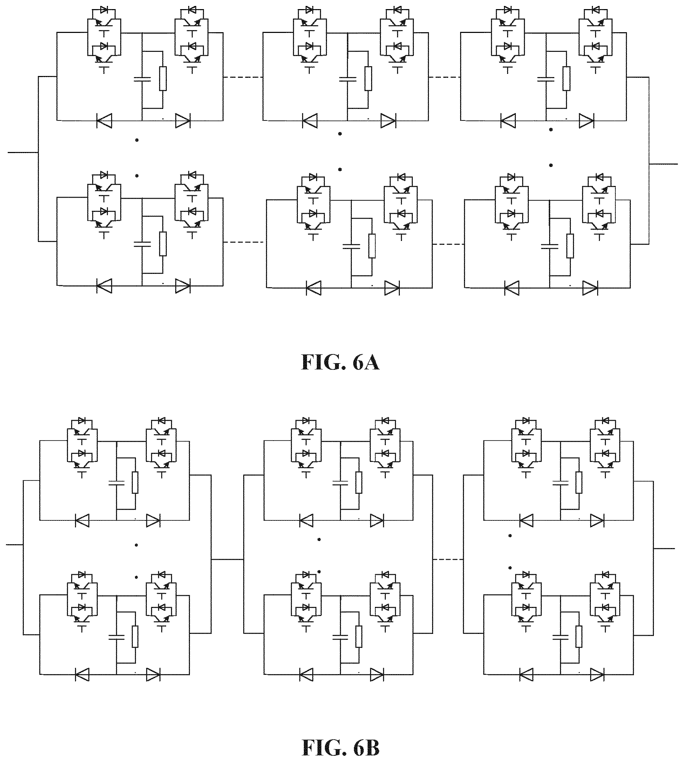

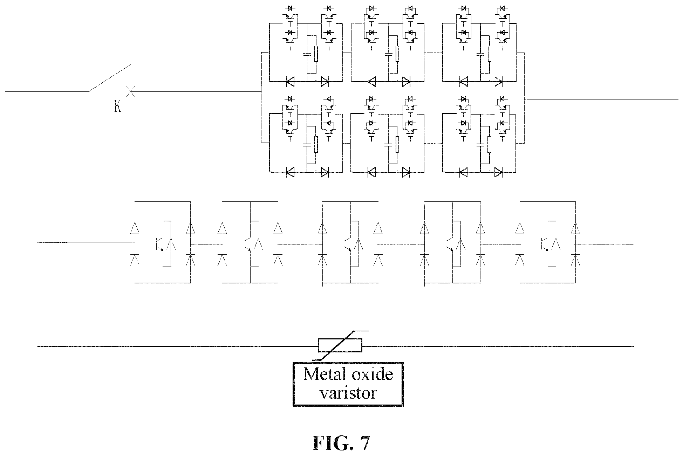

The full-bridge module provided in the present disclosure may be used for the design of the power electronic switch in the hybrid direct current circuit breaker. The power electronic switch in the primary path branch may be formed by a plurality of full-bridge modules connected in series and in parallel. Two modes of implementation exist: the plurality of full-bridge modules are connected first in series and then in parallel, as shown in FIG. 6A; the plurality of full-bridge modules are connected first in parallel and then in series, as shown in FIG. 6B. The power electronic switch in the transfer branch is formed by fully-controlled power electronic devices connected in series or by a plurality of units including a fully-controlled power electronic device connected in series. As shown in FIG. 7, the topology of the hybrid direct current circuit breaker based on a full-bridge module is used to illustrate an operation process.

When the system normally operates, a load current merely flows through the primary path branch, that is, the load current merely flows through the fast mechanical switch K and the power electronic switch of the primary path branch. At this time, controllable devices, IGBTs, in a power electronic switch are kept at a trigger state, and the load current flows through the diodes in the upper leg of a full-bridge module connected anti-parallel to the left IGBTs, flows through the two right IGBTs connected in parallel in the upper leg, and flows out of the full-bridge module. At this time, the current does not flow through the capacitor branch in the module. After a fault occurs, the hybrid direct current circuit breaker receives a system breaking command, the power electronic switch of the primary path branch is latched, and the power electronic switch in the transfer branch is kept at a trigger state. The IGBTs in the power electronic switch of the primary path branch are turned off. At this time, the fault current flows through the capacitor branch in the module to charge the capacitor. When the voltage across two ends of the circuit breaker reaches the turn-on voltage of the transfer branch, the fault current is transferred from the primary path branch to the transfer branch. After the transfer is completed, the fast mechanical switch K is broken. After the fast mechanical switch K is broken, the power electronic switch of the transfer branch is latched to achieve the transfer of the current from the transfer branch to the energy absorption branch and to complete fault current breaking. The direct current circuit breaker has basically the same off and on process as a cascade full-bridge direct current circuit breaker. The transfer branch is turned on, and if turn-on is performed on a sound line, the primary path branch is triggered; if turn-on is performed on a fault line, the transfer branch is latched.

The embodiments of the present application may be provided as methods, systems or computer program products. Therefore, the present application may take the form of completely hardware embodiments, completely software embodiments, or a combination of software and hardware embodiments. Moreover, the present application may take the form of a computer program product implemented on one or more computer-usable storage media (including a disk memory, a compact disc read-only memory (CD-ROM), an optical memory, etc.) that include computer-usable program codes.

The present application is described with reference to flowcharts and/or block diagrams of methods, devices (systems) and computer program products according to the embodiments of the present application. In the present application, computer program instructions may be used to implement each flow and/or block in the flowcharts and/or block diagrams and a combination of flows and/or blocks in the flowcharts and/or block diagrams. These computer program instructions may be provided for a processor of a general-purpose computer, a special-purpose computer, an embedded processor or another programmable data processing device to produce a machine, so that instructions, which are executed via the processor of the computer or another programmable data processing equipment, create a means for implementing the functions specified in one or more flows in the flowcharts and/or in one or more blocks in the block diagrams.

These computer program instructions may also be stored in a computer-readable memory which is able to direct a computer or another programmable data processing device to operate in a particular manner, so that the instructions stored in the computer-readable memory produce an article of manufacture including instruction means which implement the functions specified in one or more flows in the flowcharts and/or in one or more blocks in the block diagrams.

These computer program instructions may also be loaded onto a computer or another programmable data processing device so that a series of operation steps are performed on the computer or another programmable device to produce processing implemented by a computer. Therefore, instructions executed on a computer or another programmable device provide steps for implementing the functions specified in one or more flows in the flowcharts and/or in one or more blocks in the block diagrams.

## Claims

1. A full-bridge module, comprising: two power electronic units, two diodes, a resistor and a capacitor;
wherein each of the two power electronic units comprises one or more sub-modules, each of the one or more sub-modules is formed by a fully-controlled power electronic device in inverse-parallel connection with one diode, the two power electronic units are connected in reverse series to form an upper leg, and the connection of the two power electronic units in reverse series comprises one or more anodes of one diode or more diodes comprised in one of the two power electronic units and one or more anodes of one diode or more diodes comprised in the other of the two power electronic units being connected together;
the two diodes are connected in reverse series to form a lower leg, the connection of the two diodes in reverse series comprising the cathodes of the two diodes being connected together, and
the resistor and the capacitor are connected in parallel and then connected between the upper leg and the lower leg;
wherein a direction of a diode of each of the two power electronic units is opposite to a direction of one diode of the lower leg corresponding to the each of the two power electronic units;
and
wherein the one or more sub-modules comprises a plurality of sub-modules, the plurality of sub-modules are connected in a manner comprising: in series, in parallel, first in series and then in parallel, or first in parallel and then in series.

2. The full-bridge module of claim 1, wherein the fully-controlled power electronic device comprises: an insulated gate bipolar transistor, IGBT, an integrated gate commutated thyristor, IGCT, an injection enhanced gate transistor, IEGT, or a gate turn-off thyristor, GTO.

3. A hybrid direct current circuit breaker based on a full-bridge module, comprising: a primary path branch, a transfer branch and an energy absorption branch, wherein the primary path branch, the transfer branch and the energy absorption branch are connected in parallel;
wherein the primary path branch comprises a plurality of full-bridge modules of any one of claims 1 to 2;
the transfer branch comprises a plurality of fully-controlled power electronic devices or a plurality of units comprising a fully-controlled power electronic device; and
the primary path branch further comprises a switch connected in series to the plurality of full-bridge modules.

4. The hybrid direct current circuit breaker of claim 3, wherein the energy absorption branch comprises a varistor.

5. The hybrid direct current circuit breaker of claim 3, wherein the plurality of full-bridge modules in the primary path branch are connected first in parallel and then in series or connected first in series and then in parallel.

6. The hybrid direct current circuit breaker of claim 3, wherein the plurality of fully-controlled power electronic devices or the plurality of units comprising the fully-controlled power electronic device in the transfer branch are connected in series.

7. An application method of the hybrid direct current circuit breaker of any one of claims 3 to 6, comprising:
in response to a system in which the hybrid direct current circuit breaker is located operating normally, closing the switch of the primary path branch of the hybrid direct current circuit breaker and keeping the plurality of full-bridge modules of the primary path branch at a trigger state;
in response to the system in which the hybrid direct current circuit breaker is located being failed, turning off the plurality of full-bridge modules of the primary path branch, keeping a fully-controlled power electronic device of the transfer branch at a trigger state, and after a fault current is transferred to the transfer branch, opening the switch of the primary path branch; and
after the fault current is transferred to the energy absorption branch of the hybrid direct current circuit breaker, clearing, by the hybrid direct current circuit breaker, the fault current.

8. The method of claim 7, wherein in response to the system in which the hybrid direct current circuit breaker is located operating normally, the closing the switch of the primary path branch of the hybrid direct current circuit breaker and keeping the plurality of full-bridge modules of the primary path branch at the trigger state comprises:
a current passing from an input end through a diode connected anti-parallel to a fully-controlled power electronic device in one of the two power electronic units of the upper leg of the full-bridge module, and then passing through a fully-controlled power electronic device in the other of the two power electronic units of the upper leg to flow out of the full-bridge module.

9. The method of claim 7, wherein in response to the system in which the hybrid direct current circuit breaker is located being failed, turning off the plurality of full-bridge modules of the primary path branch, keeping the fully-controlled power electronic device of the transfer branch at the trigger state, and after the fault current is transferred to the transfer branch, opening the switch of the primary path branch comprises:
based on a received breaking command, turning off a fully-controlled power electronic device of the plurality of full-bridge modules of the primary path branch, and charging capacitors of the plurality of full-bridge modules of the primary path branch through the fault current;
in response to a voltage across two ends of the hybrid direct current circuit breaker reaching a turn-on voltage of the transfer branch, transferring the fault current to the transfer branch; and
opening the switch of the primary path branch after the fault current transfer is completed.

## Patentansprüche

1. Vollbrückenmodul, umfassend: zwei Leistungselektronikeinheiten, zwei Dioden, einen Widerstand und einen Kondensator;
wobei jede der beiden Leistungselektronikeinheiten ein oder mehrere Submodule umfasst, von denen jedes durch eine vollständig gesteuerte Leistungselektronikvorrichtung in inverser Parallelschaltung mit einer Diode gebildet wird, wobei die beiden Leistungselektronikeinheiten in umgekehrter Reihenschaltung verbunden sind, um einen oberen Zweig zu erzeugen, wobei die Verbindung der beiden Leistungselektronikeinheiten in umgekehrter Reihenschaltung eine oder mehrere Anoden einer Diode oder mehrerer Dioden, die in einer der beiden Leistungselektronikeinheiten enthalten sind, und eine oder mehrere Anoden einer Diode oder mehrerer Dioden, die in der anderen der beiden Leistungselektronikeinheiten enthalten sind, umfasst, die miteinander verbunden sind;
die beiden Dioden in umgekehrter Reihenschaltung verbunden sind, um einen unteren Zweig zu erzeugen, wobei die Verbindung der beiden Dioden in umgekehrter Reihenschaltung die Kathoden der beiden Dioden umfasst, die miteinander verbunden sind, und
der Widerstand und der Kondensator parallel geschaltet und dann zwischen dem oberen Zweig und dem unteren Zweig geschaltet sind;
wobei die Richtung einer Diode jeder der beiden Leistungselektronikeinheiten entgegengesetzt zur Richtung einer Diode des unteren Zweigs ist, der jeder der beiden Leistungselektronikeinheiten entspricht;
und
wobei das eine oder die mehreren Submodule eine Vielzahl von Submodulen umfassen, wobei die Vielzahl von Submodulen in einer Weise verbunden sind, die Folgendes umfasst: in Reihe, parallel, zuerst in Reihe und dann parallel oder zuerst parallel und dann in Reihe.

2. Vollbrückenmodul nach Anspruch 1, wobei die vollständig gesteuerte Leistungselektronikvorrichtung einen Bipolartransistor mit isoliertem Gate (IGBT), einen integrierten Gate-kommutierten Thyristor (IGCT), einen injektionsverstärkten Gate-Transistor (IEGT) oder einen Gate-Turn-Off-Thyristor (GTO) umfasst.

3. Hybrid-Gleichstrom-Leistungsschalter auf Basis eines Vollbrückenmoduls, umfassend einen Primärpfadzweig, einen Übertragungszweig und einen Energieabsorptionszweig, wobei der Primärpfadzweig, der Übertragungszweig und der Energieabsorptionszweig parallel geschaltet sind;
wobei der Primärpfadzweig mehrere Vollbrückenmodule nach einem der Ansprüche 1 bis 2 umfasst;
wobei der Übertragungszweig mehrere vollständig gesteuerte Leistungselektronikvorrichtungen oder mehrere Einheiten mit einer vollständig gesteuerten Leistungselektronikvorrichtung umfasst; und wobei der Primärpfadzweig ferner einen Schalter umfasst, der mit den mehreren Vollbrückenmodulen in Reihe geschaltet ist.

4. Hybrid-Gleichstrom-Leistungsschalter nach Anspruch 3, wobei der Energieabsorptionszweig einen Varistor umfasst.

5. Hybrid-Gleichstrom-Leistungsschalter nach Anspruch 3, wobei die mehreren Vollbrückenmodule im Primärpfadzweig zuerst parallel und dann in Reihe geschaltet oder zuerst in Reihe und dann parallel geschaltet sind.

6. Hybrid-Gleichstrom-Leistungsschalter nach Anspruch 3, wobei die mehreren vollständig gesteuerten Leistungselektronikvorrichtungen oder die mehreren Einheiten mit der vollständig gesteuerten Leistungselektronikvorrichtung im Übertragungszweig in Reihe geschaltet sind.

7. Verfahren zur Anwendung des Hybrid-Gleichstrom-Leistungsschalters nach einem der Ansprüche 3 bis 6, umfassend:
Schließen des Schalters des Primärpfadzweigs des Hybrid-Gleichstrom-Leistungsschalters und Halten der mehreren Vollbrückenmodule des Primärpfadzweigs in einem Auslösezustand als Reaktion darauf, dass ein System, in dem sich der Hybrid-Gleichstrom-Leistungsschalter befindet, normal betrieben wird;
Ausschalten der mehreren Vollbrückenmodule des Primärpfadzweigs, Halten einer vollständig gesteuerten Leistungselektronikvorrichtung des Übertragungszweigs in einem Auslösezustand und Öffnen des Schalters des Primärpfadzweigs, nachdem ein Fehlerstrom zum Übertragungszweig übertragen wurde, als Reaktion darauf, dass das System, in dem sich der Hybrid-Gleichstrom-Leistungsschalter befindet, ausgefallen ist; und
Löschen des Fehlerstroms durch den Hybrid-Gleichstrom-Leistungsschalter, nachdem der Fehlerstrom zum Energieabsorptionszweig des Hybrid-Gleichstrom-Leistungsschalters übertragen wurde.

8. Verfahren nach Anspruch 7, wobei das Schließen des Schalters des Primärpfadzweigs des Hybrid-Gleichstrom-Leistungsschalters und das Halten der mehreren Vollbrückenmodule des Primärpfadzweigs im Auslösezustand als Reaktion darauf, dass ein System, in dem sich der Hybrid-Gleichstrom-Leistungsschalter befindet, normal betrieben wird, Folgendes umfassen:
ein Strom fließt von einem Eingangsende durch eine Diode, die antiparallel zu einer vollständig gesteuerten Leistungselektronikvorrichtung in einer der beiden Leistungselektronikeinheiten des oberen Zweigs des Vollbrückenmoduls geschaltet ist, und fließt dann durch eine vollständig gesteuerte Leistungselektronikvorrichtung in der anderen der beiden Leistungselektronikeinheiten des oberen Zweigs, um aus dem Vollbrückenmodul auszutreten.

9. Verfahren nach Anspruch 7, wobei das Ausschalten der mehreren Vollbrückenmodule des Primärpfadzweigs, das Halten der vollständig gesteuerten Leistungselektronikvorrichtung des Übertragungszweigs im Auslösezustand und das Öffnen des Schalters des Primärpfadzweigs, nachdem der Fehlerstrom zum Übertragungszweig übertragen wurde, als Reaktion darauf, dass das System, in dem sich der Hybrid-Gleichstrom-Leistungsschalter befindet, ausgefallen ist, Folgendes umfassen: Abschalten einer vollständig gesteuerten Leistungselektronikvorrichtung der mehreren Vollbrückenmodule des Primärpfadzweigs auf der Grundlage eines empfangenen Unterbrechungsbefehls und Laden von Kondensatoren der mehreren Vollbrückenmodule des Primärpfadzweigs durch den Fehlerstrom;
Übertragen des Fehlerstroms auf den Übertragungszweig als Reaktion darauf, dass eine Spannung über zwei Enden des Hybrid-Gleichstrom-Leistungsschalters eine Einschaltspannung des Übertragungszweigs erreicht; und
Öffnen des Schalters des Primärpfadzweigs, nachdem die Fehlerstromübertragung abgeschlossen ist.

## Revendications

1. Module à pont complet, comprenant : deux unités électroniques de puissance, deux diodes, une résistance et un condensateur ;
dans lequel chacune des deux unités électroniques de puissance comprend un ou plusieurs sous-modules, chacun des un ou plusieurs sous-modules est formé par un dispositif électronique entièrement contrôlé en connexion parallèle inversée avec une diode, les deux unités électroniques de puissance sont connectées en série inversée pour former une patte supérieure, et la connexion des deux unités électroniques de puissance en série inversée comprend une ou plusieurs anodes d'une diode ou de plusieurs diodes comprises dans l'une des deux unités électroniques de puissance et une ou plusieurs anodes d'une diode ou de plusieurs diodes comprises dans l'autre des deux unités électroniques de puissance étant connectées ensemble ;
les deux diodes sont connectées en série inversée pour former une patte inférieure, la connexion des deux diodes en série inversée comprenant les cathodes des deux diodes étant connectées ensemble, et
la résistance et le condensateur sont connectés en parallèle puis connectés entre la patte supérieure et la patte inférieure ;
dans lequel le sens de la diode de chacune des deux unités électroniques de puissance est opposé au sens d'une diode de la patte inférieure correspondant à chacune des deux unités électroniques de puissance ;
et
dans lequel les un ou plusieurs sous-modules comprennent une pluralité de sous-modules, la pluralité de sous-modules est connectée d'une manière comprenant : en série, en parallèle, d'abord en série puis en parallèle, ou d'abord en parallèle puis en série.

2. Module à pont complet selon la revendication 1, dans lequel le dispositif électronique entièrement contrôlé comprend : un transistor bipolaire à grille isolée, IGBT, un thyristor commuté à gâchette intégrée, IGCT, un transistor à grille amélioré par injection, IEGT, ou un thyristor blocable par la gâchette, GTO.

3. Disjoncteur hybride à courant continu basé sur un module à pont complet, comprenant : une ramification de chemin primaire, une ramification de transfert et une ramification d'absorption d'énergie, dans lequel la ramification de chemin primaire, la ramification de transfert et la ramification d'absorption d'énergie sont connectées en parallèle ;
dans lequel la ramification de chemin primaire comprend une pluralité de modules à pont complet selon l'une quelconque des revendications 1 à 2 ;
la ramification de transfert comprend une pluralité de dispositifs électroniques entièrement contrôlés ou une pluralité d'unités comprenant un dispositif électronique entièrement contrôlé ; et la ramification de chemin primaire comprend en outre un commutateur connecté en série à la pluralité de modules à pont complet.

4. Disjoncteur hybride à courant continu selon la revendication 3, dans lequel la ramification d'absorption d'énergie comprend une varistance.

5. Disjoncteur hybride à courant continu selon la revendication 3, dans lequel la pluralité de modules à pont complet dans la ramification de chemin primaire est connectée d'abord en parallèle puis en série ou est connectée d'abord en série puis en parallèle.

6. Disjoncteur hybride à courant continu selon la revendication 3, dans lequel la pluralité de dispositifs électroniques entièrement contrôlés ou la pluralité d'unités comprenant le dispositif électronique entièrement contrôlé dans la ramification de transfert est connectée en série.

7. Procédé d'application disjoncteur hybride à courant continu selon l'une quelconque des revendications 3 à 6, comprenant :
en réponse à un système dans lequel le disjoncteur hybride à courant continu est situé fonctionne normalement, fermer le commutateur de la ramification de chemin primaire du disjoncteur hybride à courant continu et conserver la pluralité de modules à pont complet de la ramification de chemin primaire en état de déclenchement ;
en réponse à un système dans lequel le disjoncteur hybride à courant continu est situé est défectueux, éteindre la pluralité de modules à pont complet de la ramification de chemin primaire, conserver le dispositif électronique entièrement contrôlé de la ramification de transfert en état de déclenchement, et une fois que le courant de défaut est transféré à la ramification de transfert, ouvrir le commutateur de la ramification de chemin primaire ; et
une fois que le courant de défaut est transféré à la ramification d'absorption d'énergie du disjoncteur hybride à courant continu, éliminer, par le disjoncteur hybride à courant continu, le courant de défaut.

8. Procédé selon la revendication 7, dans lequel en réponse à un système dans lequel le disjoncteur hybride à courant continu est situé est défectueux, éteindre la pluralité de modules à pont complet de la ramification de chemin primaire, et conserver le dispositif électronique entièrement contrôlé de la ramification de transfert en état de déclenchement comprend :
un courant passant d'une terminaison d'entrée via une diode connectée en antiparallèle à un dispositif électronique entièrement contrôlé dans l'une des deux unités électroniques de puissance de la patte supérieure du module à pont complet, puis passant à travers un dispositif électronique entièrement contrôlé dans l'autre des deux unités électroniques de puissance de la patte supérieure du module à pont complet.

9. Procédé selon la revendication 7, dans lequel en réponse à un système dans lequel le disjoncteur hybride à courant continu est situé est défectueux, éteindre la pluralité de modules à pont complet de la ramification de chemin primaire, conserver le dispositif électronique entièrement contrôlé de la ramification de transfert en état de déclenchement, et une fois que le courant de défaut est transféré à la ramification de transfert, ouvrir le commutateur de la ramification de chemin primaire comprend : en se basant sur une commande de coupure reçue, éteindre le dispositif électronique entièrement contrôlé de la pluralité de modules à pont complet de la ramification de chemin primaire, et charger les condensateurs de la pluralité de modules à pont complet de la ramification de chemin primaire via le courant de défaut ;
en réponse à une tension sur deux terminaisons du disjoncteur hybride à courant continu atteignant une tension de mise en marche de la ramification de transfert, transférer le courant de défaut à la ramification de transfert ; et
ouvrir le commutateur de la ramification de transfert une fois que le transfert du courant de défaut est achevé.
